# EUROPEAN PATENT SPECIFICATION

(11) **EP 0 543 784 B1**
(45) Date of publication and mention of the grant of the patent: **06.09.1995**
(21) Application number: 92830616.6
(22) Date of filing: 10.11.1992
(51) Int. Cl.: C23C 14/02

(54) **A method for the surface treatment by laser radiation of metals to be coated**
Verfahren zur Oberflächenbehandlung mittels Laserbestrahlung von zu beschichtenden Metallen
Procédé de traitement en surface utilisant l'irradiation par laser de métaux à revêtir

(30) Priority: 22.11.1991 IT TO910902
(43) Date of publication of application: 26.05.1993
(73) Proprietor: FIAT AUTO S.p.A., 10135 Torino (IT)
(72) Inventor: Da Re', Mario, I-10128 Torino (IT)
(74) Representative: Gerbino, Angelo

(56) References cited:
- EP-A- 0 276 461
- US-A- 4 281 030

## Description

The present invention relates to a method for the surface treatment of metals to be coated with a layer of material having characteristics of hardness and resistance to wear, for example, titanium nitride or titanium carbonitride. This coating layer usually has a thickness of between 1 and 4 µ and a hardness of between 2,300 and 3,200 HV. This may be deposited by various techniques, for example, by physical vapour deposition (PVD).

HSS steels, steels for hot or cold working, brought three times to the maximum temperature for secondary tempering, are examples of metals which may be coated in the manner indicated above.

In order for the coating treatment to be successful, however this is carried out, it is essential for the metal surface to be treated to be perfectly clean and regular. For this purpose, in the prior art, the pieces to be coated have previously been smoothed accurately, for example by grinding or blasting and then subjected to a series of washings with suitable solvents to remove the surface impurities present.

Furthermore, according to prior document EP-A-276 461, it is known to irradiate with laser radiation the surface of a metal prior of its coating.

The object of the present invention is to provide a quicker and more effective process than the conventional ones for the surface treatments of metals to be coated with a layer of material having characteristics of hardness and resistance to wear.

This object is achieved by virtue of the method indicated in claim 1.

According to the method of the invention the neodymium-YAG radiation makes the impurities sublime from the surface while the CO₂ radiation, which is more powerful than the previous radiation, melts any roughness on the metal part, smoothing its surface.

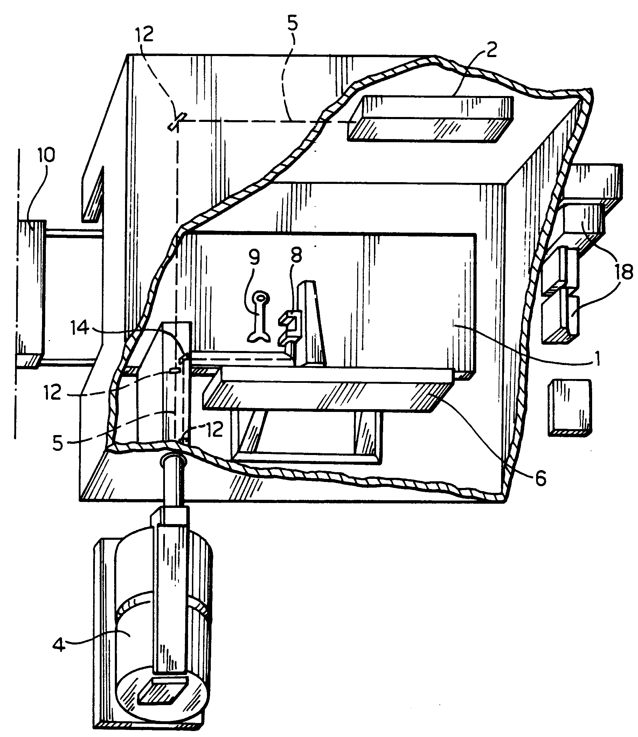

Advantages and characteristics of the present invention will become clear from the detailed description which follows, given with reference to the appended drawing provided purely by way of non-limiting example, which illustrates schematically and in plan an apparatus for carrying out a method according to the invention.

An apparatus for the surface treatment of metal parts 9 to be coated with a layer of material having characteristics of hardness and resistance to wear, for example titanium nitride or titanium carbonitride, includes a neodymium-YAG laser 2 and a CO₂ laser 4 for emitting laser radiation 5.

The apparatus further includes a 5-axis robot 6 of known type for supporting a head 8 which outputs the laser radiation, a feed device 10 for feeding the parts 9 to be treated, a work table 1 and a combination of mirrors for conducting the laser radiation 5 from the emission devices 2, 4 to the part 9 through the head 8. More particularly, these include fixed mirrors 12 and a commutable mirror 14 for reflecting selectively the radiation from the device 2 or from the device 4 to the head 8 mounted on the robot 6. A process control computer 18 governs the movements of the robot 6 and the output of radiation by the devices 2 and 4.

The operation of the apparatus is as follows:-
Once a part 9 to be treated has been transferred from the feed device 10 to the work table 1, the neodymium-YAG laser 2 is activated and the commutable mirror 14 is rotated through 90° from the position illustrated in the drawing so as to reflect the radiation from the device 2. The robot 6 being made to carry out suitable movements, the entire surface of the part 9 is irradiated at a power of between 500 and 3,000 W/cm² according to the type of material to be treated and with a speed of traverse of the laser over the surface of the part of between 0.05 and 0.1 m/minute. The angle of incidence of the laser radiation on the surface to be treated is substantially 90°. Thus the surface impurities, such as grinding residues from the smoothing process, oxide layers, white residues from electro-erosion processes, organic residues and the like are made to sublime.

The commutable mirror 14 is then returned to the position illustrated in the drawing and the CO₂ laser 4 is activated. With suitable movements of the robot 6, the entire surface of the part 9 is again irradiated at a power of between 5,000 and 25,000 W/cm² and with a speed of traverse of the laser over the surface of the part of between 0.1 and 1.1 m/minute. The angle of the incidence of the laser radiation is again substantially 90°.

The CO₂ laser radiation, which is more powerful than that used previously, levels the surface of the part by melting the peaks causing the roughness. The treated part is thus ready for the surface coating operation which will be carried out subsequently by techniques known per se.

Naturally, the principle of the invention remaining the same, its forms of embodiment may be varied widely with respect to that described and illustrated without thereby departing from its scope. For example, the laser irradiation may be carried out under vacuum in such a manner as to facilitate the removal of material from the treated surfaces.

## Claims

1. A method for the surface treatment of metals to be coated with a layer of material having characteristics of hardness and resistance to wear, wherein the metal surface (9) to be coated is irradiated with laser radiation, said method being characterised in that the irradiation is carried out firstly with a neodymium-YAG laser (2) and then with a CO₂ laser (4).

2. A method according to Claim 1, characterised in that irradiation with the neodymium-YAG laser (2) is carried out at a power of between 500 and 3,000 W/cm² of the surface of the part (9) to be treated and with a speed of traverse of the laser over the surface of between 0.05 and 0.1 m/minute, while the irradiation with the CO₂ laser is carried out at a power of between 5,000 and 25,000 W/cm² of surface of the part (9) to be treated and with a speed of traverse of the laser over the surface of between 0.1 and 1.1 m/minute.

3. A method according to any one of the preceding claims, characterised in that the laser radiations (5) are incident substantially at right angles to the metal surface (9) to be treated.

4. A method according to any one of the preceding claims, characterised in that the irradiation treatment is carried out under vacuum.

## Patentansprüche

1. Verfahren zur Oberflächenbehandlung von Metallen, die mit einer Schicht eines Härte- und Verschleißfestigkeitseigenschaften aufweisenden Materials zu überziehen sind, bei dem die zu überziehende Metalloberfläche (9) mit Laserstrahlung bestrahlt wird, wobei das Verfahren dadurch gekennzeichnet ist, daß die Bestrahlung zuerst mit einem Neodym-YAG-Laser (2) und dann mit einem CO₂-Laser (4) durchgeführt wird.

2. Verfahren nach Anspruch 1,
dadurch gekennzeichnet, daß eine Bestrahlung mit dem Neodym-YAG-Laser (2) bei einer Leistung zwischen 500 und 3000 W/cm² der Oberfläche des zu behandelnden Teils (9) und mit einer Überquerungsgeschwindigkeit des Lasers über die Oberfläche zwischen 0,05 und 0,1 m/Minute durchgeführt wird, während die Bestrahlung mit dem CO₂-Laser bei einer Leistung zwischen 5000 und 25000 W/cm² der Oberfläche des zu behandelnden Teils (9) und mit einer Überquerungsgeschwindigkeit des Lasers über die Oberfläche zwischen 0,1 und 1,1 m/Minute durchgeführt wird.

3. Verfahren nach einem der vorhergehenden Ansprüche,
dadurch gekennzeichnet, daß die Laserstrahlungen (5) im wesentlichen unter rechten Winkeln auf die zu behandelnde Metalloberfläche (9) einfallen.

4. Verfahren nach einem der vorhergehenden Ansprüche,
dadurch gekennzeichnet, daß die Bestrahlungsbehandlung unter Vakuum durchgeführt wird.

## Revendications

1. Procédé pour le traitement de surface de métaux destinés à être revêtus d'une couche de matériau ayant des caractéristiques de dureté et de résistance à l'usure, dans lequel la surface métallique (9) qui doit être revêtue est irradiée avec un rayonnement laser, ledit procédé étant caractérisé en ce que l'irradiation est réalisée tout d'abord avec un laser YAG-néodyme (2) puis avec un laser à CO₂ (4).

2. Procédé selon la revendication 1, caractérisé en ce que l'irradiation avec le laser YAG-néodyme (2) est réalisée à une puissance comprise entre 500 et 3 000 W/cm² de la surface de la pièce (9) à traiter et avec une vitesse de balayage du laser sur la surface comprise entre 0,05 et 0,1 m/min, tandis que l'irradiation avec le laser à CO₂ est réalisée à une puissance comprise entre 5 000 et 25 000 W/cm² de la surface de la pièce (9) à traiter et avec une vitesse de balayage du laser sur la surface comprise entre 0,1 et 1,1 m/min.

3. Procédé selon l'une quelconque des revendications précédentes, caractérisé en ce que les rayonnements lasers (5) frappent la surface métallique (9) à traiter sensiblement à angle droit.

4. Procédé selon l'une quelconque des revendications précédentes, caractérisé en ce que le traitement par irradiation est réalisé sous vide.
